# EUROPEAN PATENT APPLICATION

(11) **EP 3 457 158 A1**
(43) Date of publication of application: **20.03.2019**
(21) Application number: 17191783.4
(22) Date of filing: 19.09.2017
(51) Int. Cl.: G01R 33/3873

(54) **MAGNETIC RESONANCE IMAGING PASSIVE SHIM MADE OF FERROMAGNETIC MATERIAL**

(71) Applicant: Koninklijke Philips N.V., 5656 AE Eindhoven (NL)
(72) Inventor: SCHMALE, Ingo, 5656 AE Eindhoven (NL); GLEICH, Bernhard, 5656 AE Eindhoven (NL); OVERWEG, Johannes Adrianus, 5656 AE Eindhoven (NL)
(74) Representative: de Haan, Poul Erik

(57) **Abstract**

The invention provides for a magnetic resonance imaging shim (100, 300, 600, 800). The magnetic resonance imaging shim has a cuboid outer shape. The magnetic resonance imaging shim comprises multiple ferromagnetic components (104). The multiple ferromagnetic components form multiple layers. The multiple layers are laminated together. Each layer comprises multiple segmentations (207) parallel to a chosen edge (106) of the cuboid outer shape.

## Description

### FIELD OF THE INVENTION

The invention relates to magnetic resonance imaging, in particular to the shimming of magnets for magnetic resonance imaging.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is typically referred to as the B0 field or the main magnetic field. Various quantities or properties of the subject can be measured spatially using MRI. However, the quality of the magnetic resonance images is dependent upon the spatial uniformity, also called homogeneity, of the B0 field within an imaging zone. There are various methods of making the B0 field more uniform. Magnetic resonance imaging systems will often have coils, so called active shims, which can be provided with current to shim or adjust the B0 field. It is also possible to put small pieces of ferromagnetic components within the magnetic field to adjust or shim the B0 field also. These ferromagnetic components are often referred to as passive shims, and are referred to as magnetic resonance imaging shims herein.

United Sates patent US 6,778,054 B1 discloses a method for shimming a magnetic field of a magnet in a volume of interest, utilizing ferromagnetic pellets for shimming. The pellets are positioned in a nonmagnetic holder having a predetermined number of pellet holes. The method includes measuring the magnetic field of a magnet in a plurality of locations within the volume of interest, determining a nominal passive shimming mass to compensate the measured magnetic field to approximate a desired magnetic field within the volume of interest; and placing a combination of ferromagnetic pellets from a selection of full strength pellets, nearly full strength pellets, and low strength pellets in the pellet holes to approximate the nominal passive shimming mass.

### SUMMARY OF THE INVENTION

The invention provides for a magnetic resonance imaging shim, a magnetic resonance imaging system and a method in the independent claims. Embodiments are given in the dependent claims.

Magnetic resonance imaging shims, as mentioned above, may be used to passively shim a magnetic resonance imaging magnet. A difficulty in using magnetic resonance imaging shim is that there are changing magnetic fields, namely the switched gradient fields, within a magnetic resonance imaging system that can lead to eddy currents within the magnetic resonance imaging shim. These eddy currents can lead to heating of the magnetic resonance imaging shim.

Embodiments may provide for a means to reduce the heating of the magnetic resonance imaging shim. The magnetic resonance imaging shims are formed from layers of ferromagnetic components that are laminated together. The breaking up of the overall magnetic resonance imaging shim into laminated layers by its self reduces the eddy currents and thereby the heating of the magnetic resonance imaging shim. In addition, each layer comprises multiple segmentations which are parallel to a chosen edge of a cuboid outer shape of the magnetic resonance imaging shim. The presence of these multiple segmentations reduces the path that eddy currents can take within a layer. This further reduces the eddy currents, which again reduces the heating of the magnetic resonance imaging shim.

In one aspect the invention provides for a magnetic resonance imaging shim. The magnetic resonance imaging shim may also be referred to as a passive magnetic resonance imaging shim. The magnetic resonance imaging shim has a cuboid outer shape. A cuboid outer shape may also alternatively be described as a rectangular prism shape. The magnetic resonance imaging shim comprises multiple ferromagnetic components. The multiple ferromagnetic components form multiple layers. The multiple layers are laminated together. Each layer comprises multiple segmentations parallel to a chosen edge of the cuboid outer shape. The multiple segmentations parallel to a chosen edge of the cuboid outer shape may serve to reduce the strength of eddy currents which may be generated within the magnetic resonance imaging shim. This has the benefit of less heating of the magnetic resonance imaging shim when it is used in a magnetic resonance imaging system.

The cuboid outer shape may for example be a bent cuboid that has a curvature on the chosen or another edge. Often times, magnetic resonance imaging systems have a cylindrical bore or other cylindrical surface which magnetic resonance imaging shims are inserted into. The cuboid outer shape may be deformed in some examples to follow this cylindrical geometry or a section of the cylindrical geometry.

In another embodiment each of the ferromagnetic components is a wire that forms one of the multiple segmentations. The chosen edge is parallel to a length of the wire. In this example each of the multiple layers may for instance be made out of the multiple wires. The use of wires within the magnetic resonance imaging shim may serve to reduce the number of eddy currents which can be generated within the magnetic resonance imaging shim and thereby to reduce the amount of heating.

In another embodiment each of the ferromagnetic components has a rectangular cross-section perpendicular to the single extension. In this embodiment the wire may have a square or rectangular cross-section. This may be beneficial because it enables a larger amount of ferromagnetic material to be packed into the cuboid outer shape. This may provide for a more compact magnetic resonance imaging shim that still reduces the amount of eddy currents and thereby heating within the magnetic resonance imaging shim.

In another embodiment each of the ferromagnetic components has a deformed circular cross-section perpendicular to the single extension. The deformed circular cross-section is formed from the compression of the multiple ferromagnetic components. For example when the magnetic resonance imaging shim is manufactured it may be initially constructed from round or circular wires. These may be placed into a form which is then pressed. The deformed circular cross-section may be beneficial because it may have a reduced volume in comparison to a circular cross-section.

In another embodiment each of the ferromagnetic components has a circular cross-section perpendicular to the single extension. This embodiment may be beneficial because it maybe very easy and inexpensive to manufacture the magnetic resonance imaging system. The multiple layers can each be formed from multiple wires that are simply cut or placed into a form or jig for forming each of the layers. Layers may also be packed into a container that is used to position the wires during the manufacturing process.

In another embodiment each of the multiple ferromagnetic components is formed from a sheet. The sheet has multiple slots cut in parallel to the chosen edge of the sheet to form the multiple segmentations. This embodiment may be beneficial because the use of a sheet may provide for an effective means of generating a magnetic resonance imaging shim that has reduced eddy currents.

In another embodiment the multiple slots form a comb-like structure attached to a common connected region. The common connected region may provide for mechanical stability of the magnetic resonance imaging shim where the comb-like structure which is also formed from the multiple segmentations may serve to reduce the amount of eddy currents generated in the magnetic resonance imaging shim when it is used in a magnetic resonance imaging system.

In another embodiment the common connected region forms an edge of the sheet. In this example the common connected region is on one edge of the sheet and the slots are cut such that the segmentations are all on the opposite edge of the sheet. This embodiment may be beneficial because it may reduce the total number of slots which need to be cut into the sheet.

In another embodiment the multiple slots form two opposing comb-like structures. Each of the two opposing comb-like structures is attached to a common connected region. The common connected region is between the two opposing comb-like structures. This embodiment may be beneficial because the common connected region is between the edges and they provide for more mechanical stability of the magnetic resonance imaging system. The two opposing comb-like structures may be used to reduce the eddy current on the edges of the magnetic resonance imaging shim.

In another embodiment the common connected region is located along a central axis of the sheet. This embodiment may be beneficial because the magnetic resonance imaging shim is symmetric and may not introduce asymmetry when the shimming is performed.

In another embodiment each of the multiple ferromagnetic components is coated with an insulating layer. This may be beneficial because it may reduce the chances that eddy currents are able to travel between the multiple layers.

In another embodiment the insulating layer is an enamel or a varnish. This embodiment may be beneficial because enamel or varnish are effective at blocking eddy currents as well as having very good or superior thermal properties. Even if the magnetic resonance imaging shim is heated due to eddy currents within a particular multiple layer the enamel or varnish will likely not be damaged by heat.

In another embodiment the multiple ferromagnetic components comprise at least 80% iron by weight. This embodiment may be beneficial because it may help in reducing the size of the magnetic resonance imaging shim.

In another embodiment the multiple ferromagnetic components are formed by an iron cobalt alloy that comprises at least 40% cobalt by weight. This embodiment may also be beneficial because it may help in reducing the size of the magnetic resonance imaging shim.

In another aspect the invention provides for a magnetic resonance imaging system comprises a main magnet for generating a main magnetic field. The main magnet comprises one or more magnetic resonance imaging shims according to an embodiment. This example may be beneficial because the shims according to an embodiment may be heated less than conventional magnetic resonance imaging shims.

In another embodiment the magnetic resonance imaging system comprises a magnetic field gradient coil. The magnetic resonance imaging system further comprises an active gradient shield coil. The magnetic resonance imaging system further comprises a spacer between the active gradient shield coil and the magnetic field gradient coil. The active gradient shield coil is between the main magnet and the magnetic field gradient coils. The spacer is configured for receiving the one or more magnetic resonance imaging shims. This embodiment may be beneficial because there is a minimal amount of space available between the active gradient shield coil and the magnetic field gradient coils. It is also difficult to cool magnetic resonance imaging shims that are placed in this position. This embodiment may therefore provide for a system that reduces heating in magnetic resonance imaging shims.

In another embodiment the magnet comprises shim rails within the spacer. The shim rails are configured for receiving the one or more magnetic resonance imaging shims.

In another aspect the invention provides for a method of shimming the magnetic resonance imaging system with one or more magnetic resonance shims according to an embodiment. The magnetic resonance imaging system comprises a main magnet for generating a main magnetic field within an imaging zone. The method comprises measuring the main magnetic field within the imaging zone. This may be achieved in several different ways. In one method a magnetic field probe is inserted into the magnetic resonance imaging system and the main magnetic field is mapped. In other examples a phantom may be placed into the magnetic resonance imaging system and a pulse sequence which is able to measure or map the B0 field is used to measure the main magnetic field.

Next, the method further comprises calculating shim placement instructions using a passive shim placement software. Typically in magnetic resonance imaging systems the main magnetic field within the imaging zone is decomposed into spherical harmonics. The passive shim placement software can calculate the position to place shims within or adjacent to the main magnet such that these various components of the magnetic field are adjusted slightly. This may enable making the main magnetic field within the imaging zone more uniform. The method further comprises installing the one or more magnetic resonance imaging shims according to the shim placement instructions.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) maybe utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection maybe made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

Magnetic Resonance (MR) data is defined herein as being the recorded measurements of radio frequency signals emitted by atomic spins using the antenna of a Magnetic resonance apparatus during a magnetic resonance imaging scan. MRF magnetic resonance data is magnetic resonance data. Magnetic resonance data is an example of medical image data. A Magnetic Resonance Imaging (MRI) image or MR image is defined herein as being the reconstructed two or three dimensional visualization of anatomic data contained within the magnetic resonance imaging data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a magnetic resonance imaging shim;
Fig. 2 illustrates an example of a layer used to construct a magnetic resonance imaging shim;
Fig. 3 illustrates a further example of a magnetic resonance imaging shim;
Fig. 4 illustrates a further example of a layer used to construct a magnetic resonance imaging shim;
Fig. 5 illustrates a further example of a layer used to construct a magnetic resonance imaging shim;
Fig. 6 illustrates a further example of a magnetic resonance imaging shim;
Fig. 7 illustrates a further example of a layer used to construct a magnetic resonance imaging shim;
Fig. 8 illustrates a further example of a magnetic resonance imaging shim;
Fig. 9 illustrates a further example of a layer used to construct a magnetic resonance imaging shim;
Fig. 10 illustrates an example of a magnetic resonance imaging system;
Fig. 11 shows a block diagram which illustrates a method of shimming the magnetic resonance imaging system of claim 10;
Fig. 12 illustrates an example of a magnetic resonance imaging magnet;
Fig. 13 illustrates an alternate placement of a magnetic resonance imaging shim in a magnetic resonance imaging system;
Fig. 14 illustrates a further alternate placement of a magnetic resonance imaging shim in a magnetic resonance imaging system;
Fig. 15 illustrates a further alternate placement of a magnetic resonance imaging shim in a magnetic resonance imaging system; and
Fig. 16 illustrates an example of an apparatus for manufacturing a magnetic resonance imaging shim.

### DETAILED DESCRIPTION OF THE EMBODIMENTS

Like numbered elements in these figures are either equivalent elements or perform the same function. Elements which have been discussed previously will not necessarily be discussed in later figures if the function is equivalent.

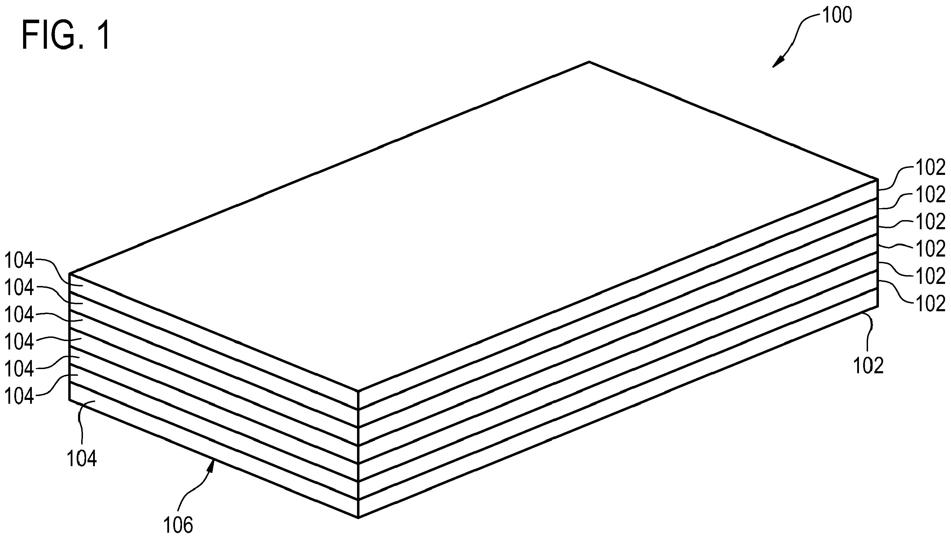

Fig. 1 illustrates an example of a magnetic resonance imaging shim 100. The magnetic resonance imaging shim is shown as comprising multiple layers 102. Each of the layers 102 comprises one or more ferromagnetic components 104. The layers 102 have been laminated together but the details of the individual layers are not shown in Fig. 1. Several different designs for the layers 102 are illustrated in the following Figs. In Fig. 1 there is an edge labeled 106 that is a chosen edge. In each of the layers there are multiple segmentations which are parallel to the chosen edge 106. These segmentations are used to break up the conduction of eddy currents within each of the layers 102. This helps to reduce the amount of heating in the magnetic resonance imaging shim 100 due to eddy currents.

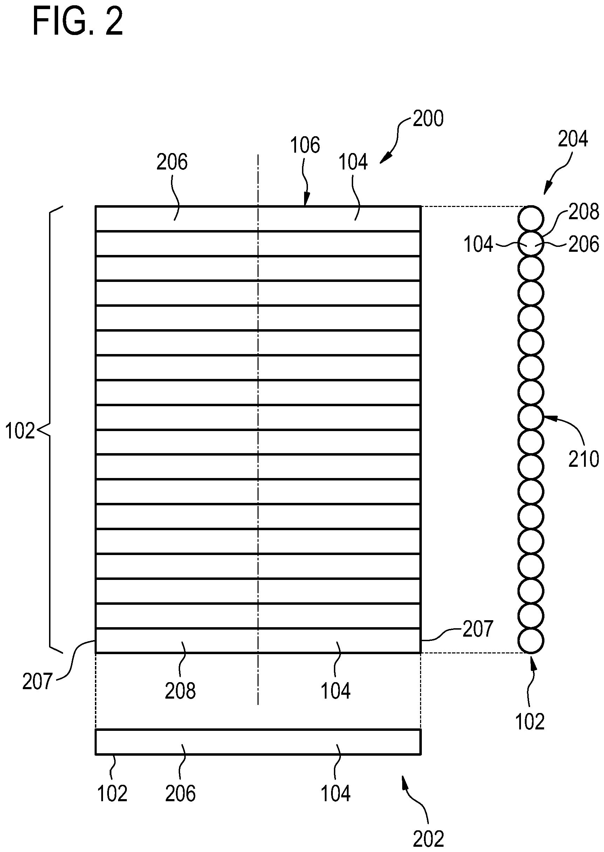

Fig. 2 shows an example of a layer 102. The layer 102 illustrated in Fig. 2 is shown as a top view 200, a front view 202, and a side view 204. The layer 102 is constructed from individual wires 206. Each wire is thin and forms at least one segmentation 207. Not all wires 206 are labeled in this Fig. The wires could for example be constructed from iron or an iron alloy. They could also be constructed from a cobalt iron alloy. The wires 206 are shown as having a circular cross-section 208. The wires 206 may also have an insulating layer 210. The insulating layer could for example be an enamel or varnish layer which would be resistant to heat damage. The insulating layer 210 prevents the conduction of current or electricity between the various wires 206. In this example each of the wires 206 is a ferromagnetic component 104. Each of the wires 206 is shown as having a cross-section 208 that is perpendicular to a chosen edge 106.

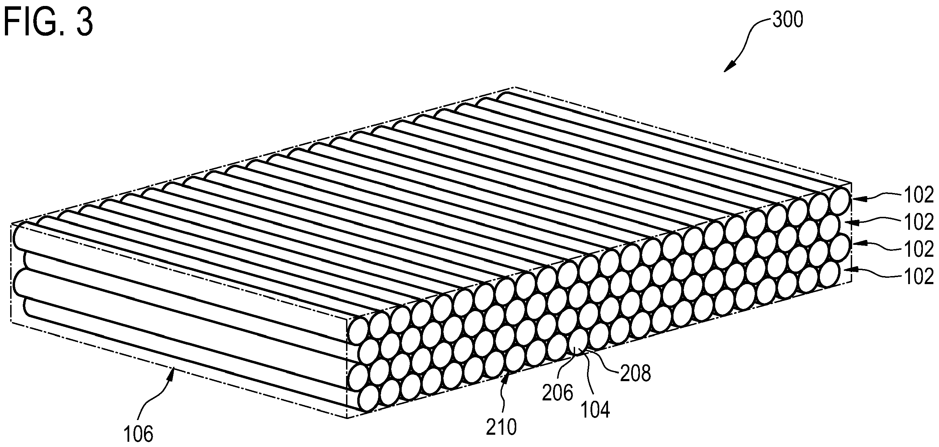

Fig. 3 illustrates a further example of a magnetic resonance imaging shim 300. The magnetic resonance imaging shim 300 is similar to that illustrated in Fig. 1 except in this case the details of the layers 102 is shown. In this example each of the layers 102 is constructed as is illustrated in Fig. 2. It can be seen that the layers are all constructed of circular wires 206. The centers of the wires are slightly offset so that they are able to pack more closely together. The chosen edge 106 is shown as a dashed line. In some examples the wires 206 may be packed within a container or embedded in a resin and this defines the chosen edge 106. In other examples the wires 206 may be simply bonded together and the chosen edge 106 is defined by an intersection between the two wires 206 along its length. It can be seen that the magnetic resonance imaging shim 300 defines a cuboid outer shape.

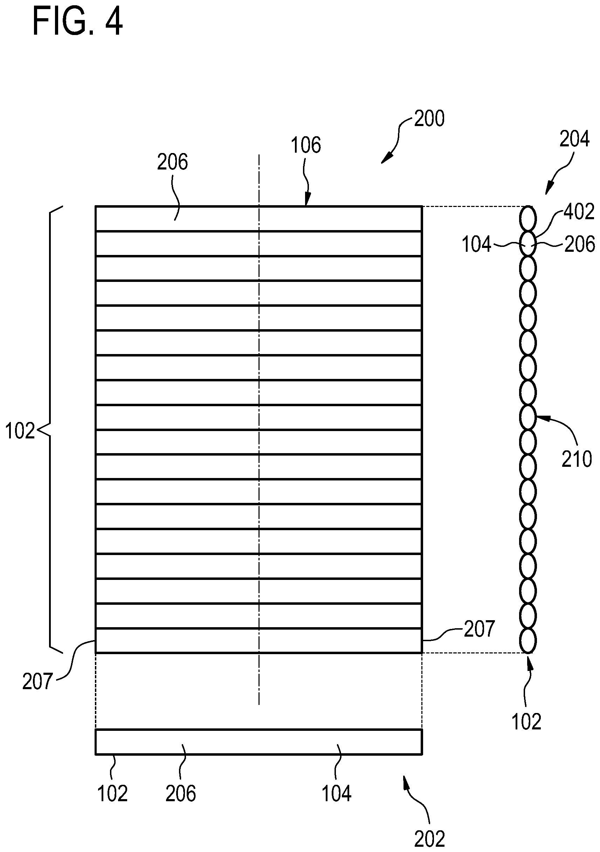

Fig. 4 illustrates a further example of a layer 102. The example illustrated in Fig. 4 is similar to the example illustrated in Fig. 2. However, the example in Fig. 4 has a deformed circular cross-section 402. The layer 102 in Fig. 4 could for example be manufactured starting with a layer 102 as illustrated in Fig. 2 and then compressing it. Each layer 102 could be compressed separately or a number of layers could be built up as is illustrated in Fig. 3 and then all compressed together. One advantage of a deformed circular cross-section 402 may be that the volume of the resulting magnetic resonance imaging shim is reduced, and hence the filling factor of the ferromagnetic material increased.

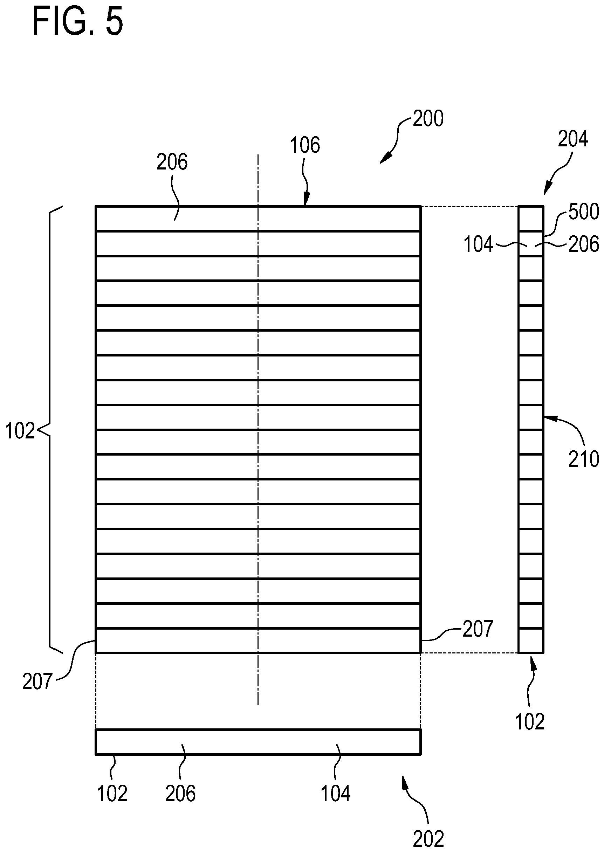

Fig. 5 illustrates a further example of a layer 102. In this example the layer 102 is again constructed from wire 206. However, the wire 206 in Fig. 5 differs from that in Figs. 2 and 4. In the example in Fig. 5 the wire 206 has a rectangular cross-section 500. In this particular example the rectangular cross-section 500 is a square cross-section. The rectangular cross-section 500 is perpendicular to the chosen edge 106. Layers such as are illustrated in Fig. 5 may have the advantage that there is very little wasted space between individual wires 206. This may enable constructing a more compact magnetic resonance imaging shim.

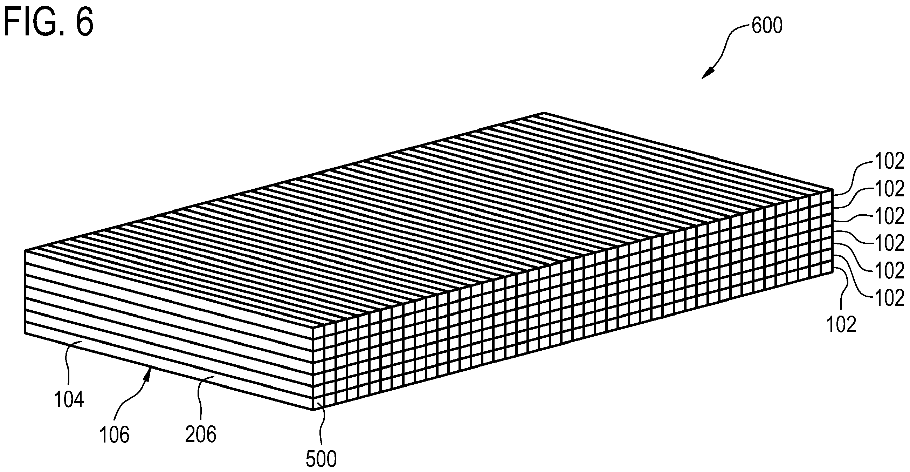

Fig. 6 illustrates a further example of a magnetic resonance imaging shim 600. The magnetic resonance imaging shim is constructed using layers 102 such as is illustrated in Fig. 5. Each layer 102 is constructed from a wire 206. Each wire 206 is a ferromagnetic component 104 that has a segmentation 207 that extends parallel to the chosen edge 106. It can be seen in Fig. 6 that there is a large number of wires 206 and there is very little wasted space between the wires 206. The magnetic resonance imaging shim 600 illustrated in Fig. 6 may therefore greatly cut down on the strength of eddy currents without a large increase in size.

The magnetic resonance imaging shim 100 illustrated in Fig. 1 is a generalization of the other magnetic resonance imaging shims which will be discussed below. The magnetic resonance imaging shim 100 typically has dimensions of about 2 x 3 cm for the width and length of a layer 102. The thickness of each of the layers 102 is typically about 0.2 mm.

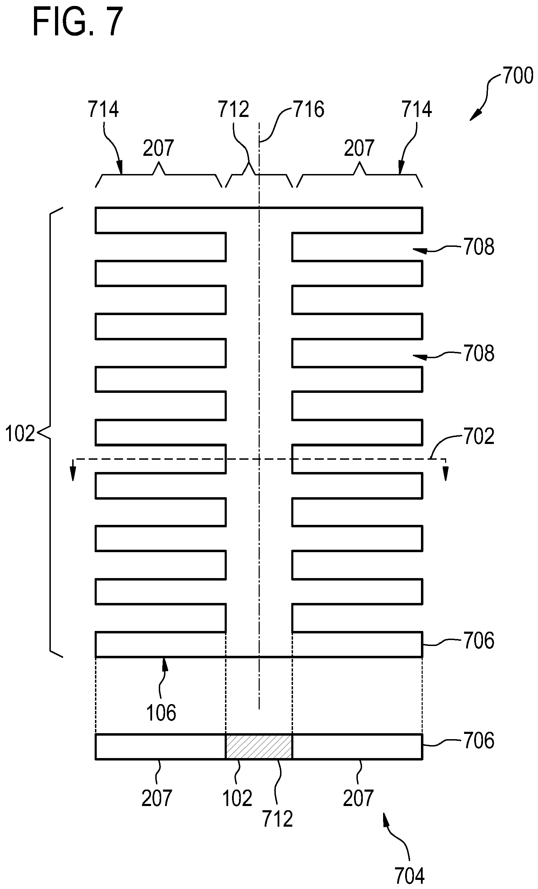

Fig. 7 illustrates a further example of a layer 102. This layer is shown in a top view 700. The top view 700 has a section line 702. There is a cross-sectional front view 704 that shows the cross-section where the section line 702 cuts the top view 700. The layer 102 is formed from a single sheet 706. There are slots 708 that have been cut perpendicular to a chosen edge 106. There are slots 708 on two opposing edges. The slots 708 form multiple segmentations 207. Centered about a central axis 716 there is a common connected region 712. The multiple segmentations 207 form two comb-like structures 714 on either side of the common connected region 712.

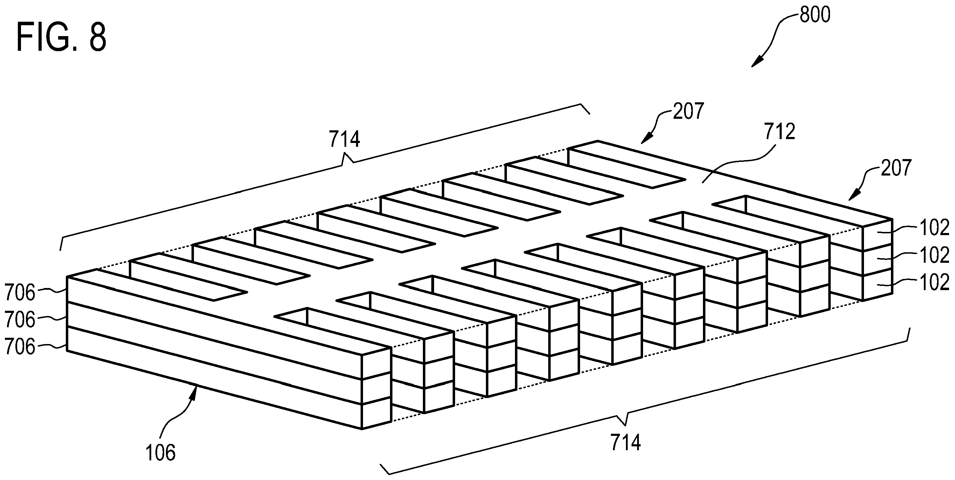

Fig. 8 shows a further example of a magnetic resonance imaging shim 800 constructed using layers 102 as is illustrated in Fig. 7. It can be seen that a number of the layers 102 have been laminated together and stacked on top of each other. Each of the layers has a common connected region 712 that forms two comb-like structures 714 on either side. In the example illustrated in Fig. 8 it can be seen that every single layer 102 is identical. This however is not necessary. The common connected region 712 could have its position shifted slightly in layer to layer. This for example could be used to make the multiple segmentations 207 more mechanically stable.

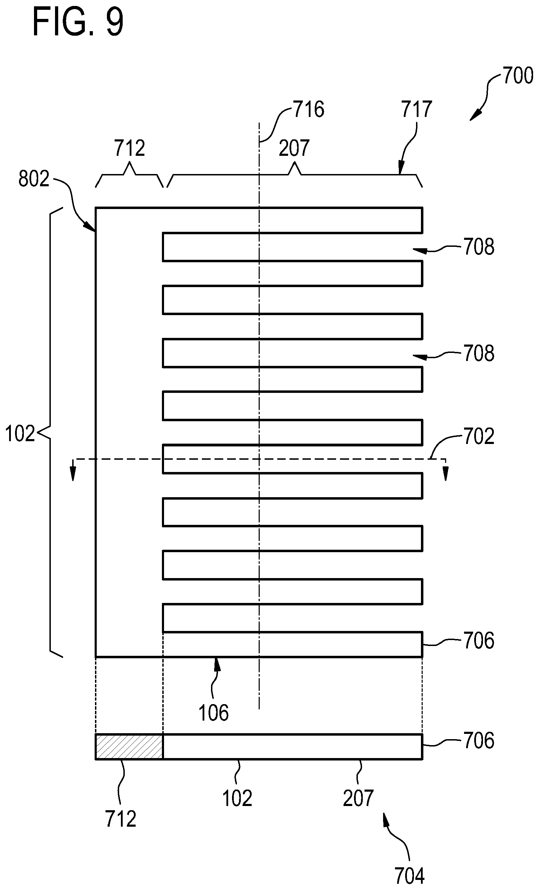

Fig. 9 illustrates a further example of a layer 102. Again this layer is made from a sheet 706. It is constructed in a manner similar to the sheet 102 illustrated in Fig. 7. However, the sheet 102 in Fig. 9 has the location of the common connected region 712 shifted to a far edge of the sheet 802 and away from the central axis 716. An entire magnetic resonance imaging shim could be constructed from layers 102 such as is illustrated in Fig. 9. The comb-like structures 714 could all be aligned and on top of each other or each layer could be flipped so that the tip of the comb-like structure 714 is laminated to a common connected region 712. This may for example have the advantage of making the resulting magnetic resonance imaging shim more stable and mechanically robust. Likewise, the layer 102 shown in Fig. 9 could also be used to construct a magnetic resonance imaging shim using the layer 102 of Fig. 7. The layer 102 of Fig. 7 could be laminated alternating with the layer 102 shown in Fig. 9. In alternating layers 102 of Fig. 9 the orientation of the common connected region 712 could also be flipped. Such an arrangement may also make the resulting magnetic resonance imaging shim 800 more mechanically stable.

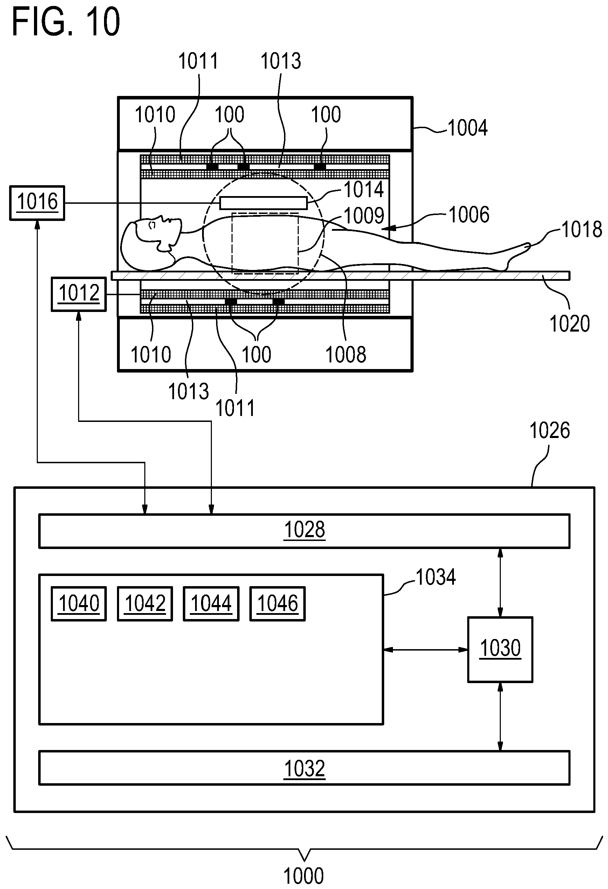

Fig. 10 shows an example of a magnetic resonance imaging system 1000 with a magnet 1004. The magnet 1004 is a superconducting cylindrical type magnet with a bore 1006 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils. Within the bore 1006 of the cylindrical magnet 1004 there is an imaging zone 1008 where the magnetic field is strong and uniform enough to perform magnetic resonance imaging. A region of interest 1009 is shown within the imaging zone 1008. A subject 1018 is shown as being supported by a subject support 1020 such that at least a portion of the subject 1018 is within the imaging zone 108 and the region of interest 1009.

Within the bore 1006 of the magnet there is also a set of magnetic field gradient coils 1010 which is used for acquisition of preliminary magnetic resonance data to spatially encode magnetic spins within the imaging zone 1008 of the magnet 1004. The magnetic field gradient coils 1010 connected to a magnetic field gradient coil power supply 1012. The magnetic field gradient coils 1010 are intended to be representative. Typically magnetic field gradient coils 1010 contain three separate sets of coils for spatially encoding in three orthogonal spatial directions. A magnetic field gradient power supply supplies current to the magnetic field gradient coils. The current supplied to the magnetic field gradient coils 1010 is controlled as a function of time and may be ramped or pulsed.

Within the bore 1006 of the magnet 1004 there can be seen to be an active shield coil 1010. The active shield coil 1010 is located within the magnetic field gradient coils 1010. There is a spacer 1013 between the magnetic field gradient coils 1010 and the shield coil 1011. It can be seen that within the spacer 1013 there have been a number of magnetic resonance imaging shims 100 that have been placed there to shim the magnetic field within the imaging zone 1008. The shims are labeled 100 however this is intended to depict any one of the magnetic resonance imaging shims which has been depicted in a previous Fig.

Adjacent to the imaging zone 1008 is a radio-frequency coil 1014 for manipulating the orientations of magnetic spins within the imaging zone 1008 and for receiving radio transmissions from spins also within the imaging zone 1008. The radio frequency antenna may contain multiple coil elements. The radio frequency antenna may also be referred to as a channel or antenna. The radio-frequency coil 1014 is connected to a radio frequency transceiver 1016. The radio-frequency coil 1014 and radio frequency transceiver 116 may be replaced by separate transmit and receive coils and a separate transmitter and receiver. It is understood that the radio-frequency coil 1014 and the radio frequency transceiver 116 are representative. The radio-frequency coil 1014 is intended to also represent a dedicated transmit antenna and a dedicated receive antenna. Likewise the transceiver 1016 may also represent a separate transmitter and receivers. The radio-frequency coil 1014 may also have multiple receive/transmit elements and the radio frequency transceiver 1016 may have multiple receive/transmit channels. For example if a parallel imaging technique such as SENSE is performed, the radio-frequency could 1014 will have multiple coil elements.

The transceiver 1016 and the gradient controller 1012 are shown as being connected to a hardware interface 1028 of a computer system 1026. The computer system further comprises a processor 1030 that is in communication with the hardware system 1028, a memory 1034, and a user interface 1032. The memory 1034 may be any combination of memory which is accessible to the processor 1030. This may include such things as main memory, cached memory, and also non-volatile memory such as flash RAM, hard drives, or other storage devices. In some examples the memory 1030 may be considered to be a non-transitory computer-readable medium.

The computer memory 1034 is shown as having machine-executable instructions 1040 for execution by the processor 1030. The machine-executable instructions 1040 enable the processor 1030 to control the operation and function of the magnetic resonance imaging system 1000 via the hardware interface 1028. The memory 1034 is further shown as containing pulse sequence commands 1042. The pulse sequence commands are either data which can be used directly to control the magnetic resonance imaging system 1000 to acquire magnetic resonance data or it is data which can be converted into such commands. Often times the pulse sequence commands 1042 are in the form of a timing sequence or diagram which is then converted into such commands. The computer memory 1034 is further shown as containing magnetic resonance data 1044. The magnetic resonance data 1044 was acquired by the magnetic resonance imaging system 1000 by controlling it with the pulse sequence commands 1042. The machine-executable instructions 1034 are shown as further containing a magnetic resonance image 1046 which has been reconstructed from the magnetic resonance data 1044.

The magnetic resonance shims 100 are shown as being located within the spacer 1013. However, this is not necessary. The magnetic resonance shims 100 can be placed in different locations also. In some of the following Figs. alternate placings of the magnetic resonance imaging shims 100 is shown.

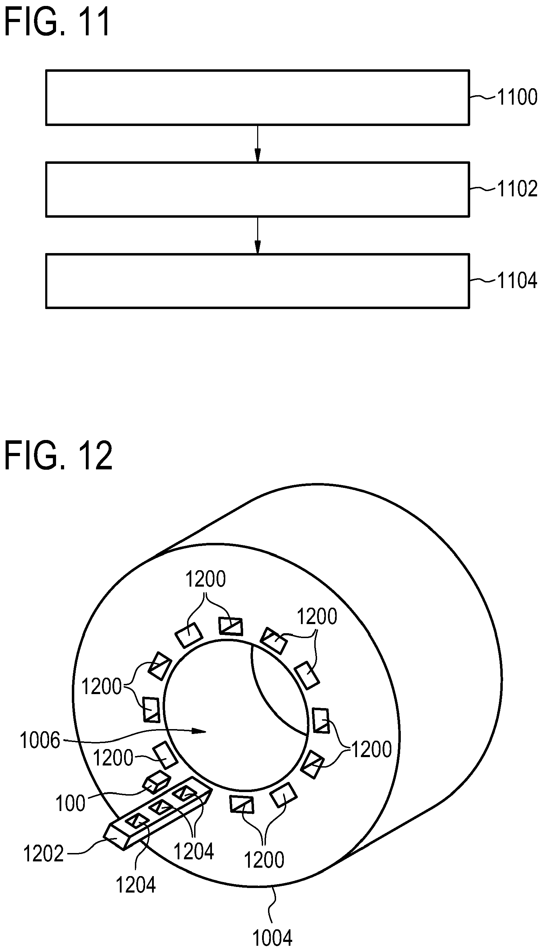

Fig. 11 shows a flowchart which illustrates a method of shimming the magnetic resonance imaging system 1000 of Fig. 10. First in step 1100 the main magnetic field within the imaging zone 1008 is measured. This may either be done using a magnetic field probe which is inserted into the bore 1006 of the magnet 1004 or it may be done by placing a phantom and measuring the magnetic field within the imaging zone 1008 using a pulse sequence that is able to measure the magnetic field. Next in step 1102 the method comprises calculating shim placement instructions using a shim placement software. Finally in step 1004 the method comprises installing the one or more magnetic resonance imaging shims according to the shim placement instructions. Often time the procedure illustrated in Fig. 11 is repeated as an iterative process. The magnetic field is shimmed once and then the method returns to step 1100 and the whole process is repeated. This progressively improves the homogeneity with each iteration.

Fig. 12 shows a further view of the magnet 1004. Again the magnet 1004 is a cylindrical type magnet. The magnet 1004 has a cylindrical bore 1006. On a side of the magnet 1004 are a number of openings 1200. Into each of the openings 1200 a shim rail 1202 can be slid. The shim rail 1202 has a number of slots 1204 for receiving the shim 100. This enables the magnetic resonance imaging shim 100 to be easily placed into the magnet 1004.

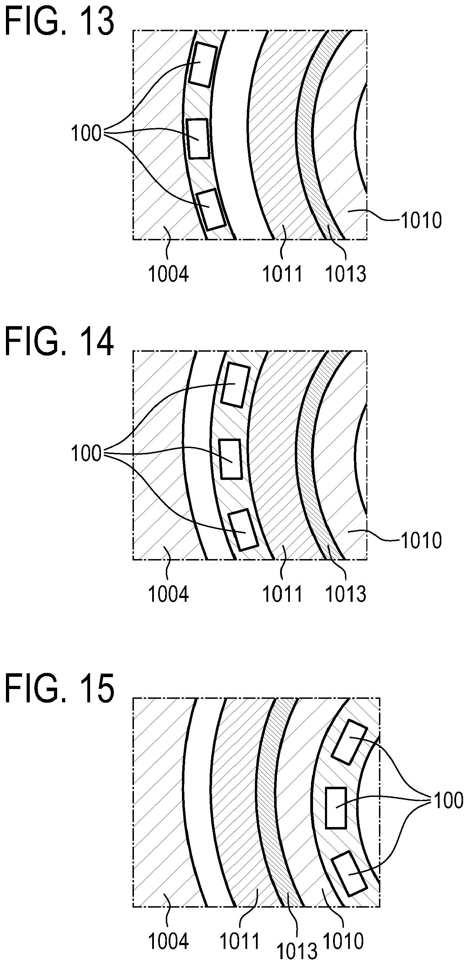

Fig. 13 illustrates an alternate placement of the magnetic resonance imaging shims 100 than was shown in Fig. 10. In Fig. 13 the magnetic resonance imaging shims 100 can be shown as being attached to the magnet 1004. The shims 100 are closer to the magnet 1004 than the shield coil 1011.

Fig. 14 shows a further variation in the placement of the magnetic resonance imaging shims 100 than was shown in Fig. 10 or Fig. 13. In Fig. 14 the magnetic resonance imaging shims 100 are again between the magnet 1004 and the shield coil 1011. However, in this example the magnetic resonance imaging shims 100 are attached to the shield coil 1011 instead of being attached to the magnet 1004 as was shown in Fig. 13.

Fig. 15 shows a further placement of the magnetic resonance imaging shims 100 than was shown in Fig. 10, 13, or 14. In the example shown in Fig. 15 the magnetic resonance imaging shims 100 are shown as being mounted closer to the center of the bore of the magnet 1004 than the magnetic field gradient coils 1010. They are essentially attached to the magnetic field gradient coils 1010.

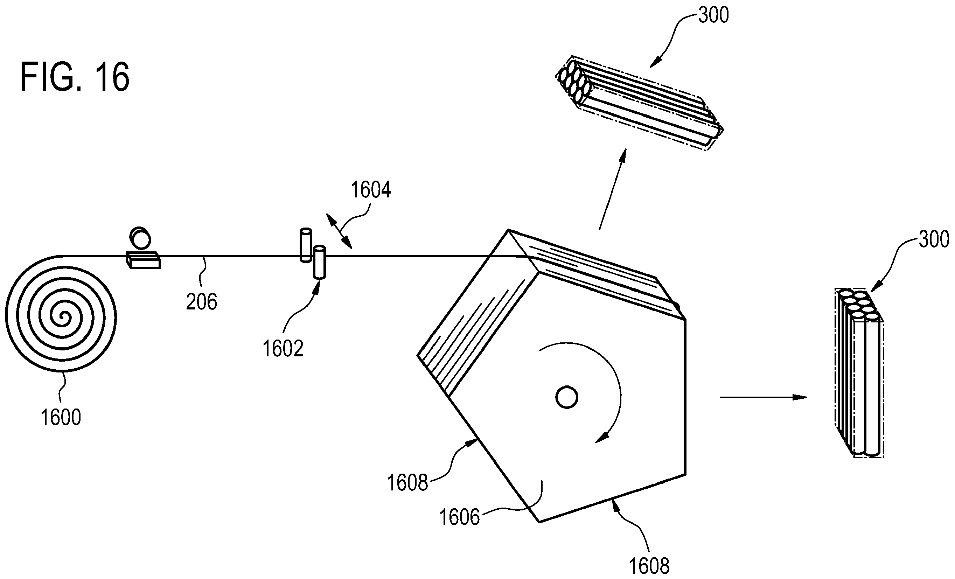

Fig. 16 illustrates an example of an apparatus which can be used to manufacture a magnetic resonance shim such as is illustrated in Fig. 3. The wire 206 is provided by a spool 1600. The wire 206 may for example be an enameled steel wire. There is a guide 1602 which controls the motion of the wire 206 in the direction 1604. The wire is then wound onto a rotating polygon-shaped drum 1606. The drum 1606 has flat sides 1608. After the steel wire 206 has been wound onto the drum 1606 the wire can be cut producing a number of the magnetic resonance imaging shims 300.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### LIST OF REFERENCE NUMERALS

- 100: magnetic resonance imaging shim
- 102: layer
- 104: ferromagnetic component
- 106: chosen edge
- 200: top view
- 202: front view
- 204: side view
- 206: wire
- 207: segmentation
- 208: circular cross section
- 210: insulating layer
- 300: magnetic resonance imaging shim
- 402: deformed circular cross section
- 500: rectangular cross section
- 600: magnetic resonance imaging shim
- 700: top view
- 702: section line
- 704: front cross sectional view
- 706: sheet
- 708: slots
- 712: common connected region
- 714: comb like structure
- 716: central axis
- 800: magnetic resonance imaging shim
- 802: edge of sheet
- 1000: magnetic resonance imaging system
- 1004: magnet
- 1006: bore of magnet
- 1008: imaging zone
- 1009: region of interest
- 1010: magnetic field gradient coils
- 1011: shield coil
- 1012: magnetic field gradient coil power supply
- 1013: spacer
- 1014: radio-frequency coil
- 1016: transceiver
- 1018: subject
- 1020: subject support
- 1026: computer system
- 1028: hardware interface
- 1030: processor
- 1032: user interface
- 1034: computer memory
- 1040: machine executable instructions
- 1042: pulse sequence commands
- 1044: magnetic resonance data
- 1046: magnetic resonance image
- 1100: measuring the main magnetic field within the imaging zone
- 1102: calculate shim placement instructions using passive shim placement software
- 1104: installing the one or more of the magnetic resonance imaging shims according to the shim placement instructions
- 1200: openings
- 1202: shim rail
- 1204: slot for receiving shim
- 1600: drum of wire
- 1602: guides
- 1604: direction of motion
- 1606: polygon shaped drum
- 1608: flat surfaces

## Claims

1. A magnetic resonance imaging shim (100, 300, 600, 800), wherein the magnetic resonance imaging shim has a cuboid outer shape, wherein the magnetic resonance imaging shim comprises multiple ferromagnetic components (104), wherein the multiple ferromagnetic components form multiple layers, wherein the multiple layers are laminated together, wherein each layer comprises multiple segmentations (207) parallel to a chosen edge (106) of the cuboid outer shape.

2. The magnetic resonance imaging shim of claim 1, wherein each of the ferromagnetic components is a wire (206) that forms one of the multiple segmentations, wherein the chosen edge is parallel to a length of the wire.

3. The magnetic resonance imaging shim of claim 2, wherein each of the ferromagnetic components has a rectangular cross section (500) perpendicular to the single extension.

4. The magnetic resonance imaging shim of claim 2, wherein each of the ferromagnetic components has a deformed circular cross section (402) perpendicular to the single extension, wherein the deformed circular cross section is formed from compression of the multiple ferromagnetic components.

5. The magnetic resonance imaging shim of claim 1, wherein each of the multiple ferromagnetic components is formed from a sheet (706), wherein the sheet has multiple slots (708) cut in parallel to the chosen edge in the sheet to form the multiple segmentations.

6. The magnetic resonance imaging system of claim 5, wherein the multiple slots form a comb like structure (714) attached to a common connected region (712).

7. The magnetic resonance imaging system of claim 6, wherein the common connected region forms an edge (802) of the sheet.

8. The magnetic resonance imaging shim of claim 5, wherein the multiple slots form two opposing comb like structures (714), wherein each of the two opposing comb like structures is attached to a common connected region (712), and wherein the common connected region is between the two opposing comb like structures.

9. The magnetic resonance imaging shim of claim 6, wherein the common connection region is located along a central axis (716) of the sheet.

10. The magnetic resonance imaging shim according to any one of the preceding claims, wherein each of the multiple ferromagnetic components is coated with an insulating layer (210).

11. The magnetic resonance imaging shim of claim 11, wherein the insulating layer is enamel or varnish.

12. The magnetic resonance imaging shim of any one of the preceding claims, wherein any one of the following:
- the multiple ferromagnetic components comprise at least 80% iron by weight; and
- the multiple ferromagnetic components are formed from an iron cobalt alloy that comprises at least 40% cobalt by weight.

13. A magnetic resonance imaging system (1000), wherein the magnetic resonance imaging system comprises a main magnet (1004) for generating a main magnetic field, wherein the main magnet comprises one or more magnetic resonance imaging shims (100, 300, 600, 800) according to any one of claims 1 through 12 for shimming the main magnetic field.

14. The magnetic resonance imaging system of claim 13, wherein the magnetic resonance imaging system comprises magnetic field gradient coils (1010), wherein the magnetic resonance imaging system further comprises an active gradient shield coil (1011), wherein the magnetic resonance imaging system further comprises a spacer (1013) between the active gradient shield coil and the magnetic field gradient coils, wherein the active gradient shield coil is between the main magnet and the magnetic field gradient coils, wherein the spacer is configured for receiving the one or more magnetic resonance imaging shims.

15. A method of shimming a magnetic resonance imaging system (1000) with one or more magnetic resonance imaging shims (100, 300, 600, 800) according to any one of claims 1 through 11, wherein the magnetic resonance imaging system comprises a main magnet for generating a main magnetic field within an imaging zone, wherein the method comprises:
- measuring (1100) the main magnetic field within the imaging zone;
- calculate (1102) shim placement instructions using passive shim placement software; and
- installing (1104) the one or more of the magnetic resonance imaging shims according to the shim placement instructions.
